# EUROPÄISCHE PATENTSCHRIFT

(11) **EP 0 774 168 B1**
(45) Veröffentlichungstag und Bekanntmachung des Hinweises auf die Patenterteilung: **27.01.1999**
(21) Anmeldenummer: 95925735.3
(22) Anmeldetag: 26.07.1995
(51) Int. Cl.: H01L 31/042, H01L 31/052

(54) **SOLARSTROMANLAGE**
SOLAR POWER GENERATION INSTALLATION
INSTALLATION DE PRODUCTION DE COURANT PAR ENERGIE SOLAIRE

(30) Priorität: 06.08.1994 DE 4427881
(43) Veröffentlichungstag der Anmeldung: 21.05.1997
(73) Patentinhaber: TNC ENERGIE-CONSULTING GMBH, 79100 Freiburg (DE)
(72) Erfinder: GOETZBERGER, Adolf, D-79249 Merzhausen (DE)
(86) Internationale Anmeldenummer: DE9500984
(87) Internationale Veröffentlichungsnummer: WO9605622

(56) Entgegenhaltungen:
- EP-A- 0 474 349
- WO-A-89/05520
- 9TH E.C. PHOTOVOLTAIC SOLAR ENERGY CONFERENCE, 25. September 1989, FREIBURG, DE Seiten 669 - 673 T. NORDMANN ET AL. 'Construction of a 100 kw grid connected PV-installation using the soundbarriers along a motorway in the swiss alps' in der Anmeldung erwähnt
- 12TH EUROPEAN PHOTOVOLTAIC SOLAR ENERGY CONFERENCE, 11. April 1994, AMSTERDAM, NL Seiten 885 - 886 J. SCHLANGEN ET AL. 'Integration of PV in a Dutch soundbarrier'
- 7TH E.C. PHOTOVOLTAIC SOLAR ENERGY CONFERENCE, 27. Oktober 1986, SEVILLA, SPANIEN Seiten 1226 - 1228 M. COLLARES-PEREIRA ET AL. 'A novel combination of low concentration CPC collectors with bifacial photovoltaic cells'
- 11TH E.C. PHOTOVOLTAIC SOLAR ENERGY CONFERENCE, 12. Oktober 1992, MONTREUX, CH Seiten 1038 - 1041 H. WILK '40 kw-photovoltaic system with IGBT inverter on the soundbarriers of motorway A1, Seewalchen-Austria'
- SOLAR ENERGY MATERIALS, Bd.21, Nr.2/3, Dezember 1990, AMSTERDAM NL Seiten 173 - 190 I.R. EDMONDS 'The performance of bifacial solar cells in static solar concentrators'

## Beschreibung

Die Erfindung betrifft eine Solarstromanlage mit wenigstens einem modularen, plattenförmigen Solarstromgenerator, der über eine sich entlang der Plattenebene erstreckende Solarzellenanordnung verfügt, deren Solarzellen beidseitig lichtempfindlich sind.

Eine derartige Solarstromanlage ist aus der EP-A-0 474 349 bekannt. Der bekannte Solarstromgenerator eignet sich für den Einsatz an Satelliten im Weltraum und weist zwischen zwei Abdeckglasplatten eingebrachte, beidseitig lichtempfindliche Solarzellen auf. Um die Sonnenstrahlung auf die lichtempfindlichen Seiten der Solarzellen zu lenken, ist der Solarzellenanordnung ein im Schnitt V-förmiger oder parabelförmiger Reflektor zugeordnet, in dessen Symmetrieebene sich die Solarzellen befinden. Der Solarstromgenerator ist üblicherweise so ausgerichtet, daß das Sonnenlicht parallel zur Solarzellenanordnung in den Reflektor einfällt.

Um den parallelen Einfall der Sonnenstrahlung zu den Abdeckplatten und Solarzellen zu gewährleisten ist es notwendig, die aus der EP-A-0 474 349 bekannten Solarstromgeneratoren der Sonne nachzuführen. Eine derartige Nachführvorrichtung ist jedoch technisch aufwendig, anfällig für Fehler und eignet sich nur eingeschränkt für Solarstromanlagen großer Leistung, die entlang Verkehrswegen vorgesehen sind.

Weiterhin ist aus den Conference Proceedings der Ninth E.C. Photovoltaic Solar Energy Conference, Freiburg, 1989, auf den Seiten 669-673 unter dem Titel "Construction of a 100KW Grid Connected PV-Installation Using the Soundbarriers along a Motorway in the Swiss Alps" eine Solarstromanlage beschrieben. Bei dieser Solarstromanlage ist eine Vielzahl von modularen plattenförmigen Solarstromgeneratoren an einer Schallschutzwand angebracht, die entlang einer Autobahn in Ost-West-Richtung verläuft. Um die Solarstromgeneratoren auf die Sonne auszurichten, sind die plattenförmigen Solarstromgeneratoren mit ihren horizontal verlaufenden Längsachsen parallel zur Schallschutzwand angeordnet und um diese Achse so verkippt, daß die Belichtungsseiten der Solarstromgeneratoren im wesentlichen nach Süden zeigen und in etwa rechtwinklig zur Einfallsrichtung der Strahlung der Mittagssonne ausgerichtet sind.

Eine weitere Solarstromanlage ist aus den Conference Proceedings der Twelfth European Photovoltaic Solar Energy Conference, Amsterdam 1994, auf den Seiten 885 und 886 unter dem Titel "Integration of PV in a Dutch Soundbarrier" bekannt. In dieser Druckschrift wird vorgeschlagen, plattenförmige Solarstromgeneratoren mit den Flächennormalen möglichst genau nach Süden ausgerichtet am oberen Wandabschluß von Schallschutzwänden anzuordnen.

Auch aus den Conference Proceedings zur Eleventh E.C. Photovoltaic Solar Energy Conference, Montreux 1992, ist auf den Seiten 1038 bis 1041 unter dem Titel "40 kW-Photovoltaic System with IGBT Inverter on the Soundbarriers of Motorway A1, Seewalchen-Austria" eine weitere Solarstromanlage bekannt, deren plattenförmige Solarstromgeneratoren auf einer Schallschutzwand um eine Längsachse verkippt und mit ihrer Flächennormalen nach Süden ausgerichtet sind.

Die bekannten Solarstromanlagen, deren Solarstromgeneratoren am oberen Wandabschluß von Schallschutzwänden entlang von Straßen angeordnet sind, lassen sich nur dann an Schallschutzwänden anbringen, wenn die Schallschutzwände im wesentlichen in Ost-West-Richtung verlaufen, da dann die plattenförmigen Solarstromgeneratoren im wesentlichen parallel zur Schallschutzwand ausgerichtet sind. Wenn die Schallschutzwand jedoch in Nord-Süd-Richtung verläuft und die plattenförmigen Solarstromgeneratoren parallel zu der Schallschutzwand ausgerichtet sind, ergeben sich bei derartigen Solarstromanlagen niedrige Energieausbeuten, da dann die Solarstromgeneratoren jeweils nur abends oder morgens von der Sonne beschienen werden. Die andere Möglichkeit, nämlich die plattenförmigen Solarstromgeneratoren quer zu einer in Nord-Süd-Richtung verlaufenden Schallschutzwand anzuordnen und sie auf diese Weise nach Süden auszurichten, setzt eine aufwendige, kostenträchtige Halteeinrichtung voraus, die verhältnismäßig viel Raum in Anspruch nimmt.

Die WO-A-89 055 20 offenbart ferner ein Solarzellenmodul, bei dem beidseitig belichtbare Solarzellen jeweils die halbe Eintrittsfläche von rinnenförmigen, im Schnitt halbkreisförmig ausgebildeten Spiegel abdecken. Ein Teil der auf das Solarzellenmodul einfallenden Sonnenstrahlung wird unmittelbar von der Vorderseite der Solarzellen absorbiert. Der andere Teil der auf das Solarzellenmodul einfallenden Sonnenstrahlung gelangt in die rinnenförmigen im Schnitt halbkreisförmigen Spiegel und wird von diesen auf die Rückseite der Solarzellen gelenkt. Die Anordnung gewährleistet, daß das auf die Vorderseite der Solarflächen einfallende Sonnenlicht auch die Rückseite der beidseitig lichtempfindlichen Solarzellen erreicht. Für einen guten Energieertrag sind die Solarmodule so auszurichten, daß die Vorderseite der Solarzellen auf die Mittagssonne ausgerichtet sind.

Die DE-A-42 19 075 offenbart eine Schallschutzwand aus Kunststoffglas mit darin eingebetteten einseitig lichtempfindlichen Solarstromgeneratoren wie beispielsweise photovoltaische Elemente. Die Solarstromgeneratoren sind zur vertikalen Ebene geneigt angeordnet und mit ihren Flächen im wesentlichen in südlicher Richtung ausgerichtet. Diese Maßnahmen führen durch eine weitgehend rechtwinklige Ausrichtung der lichtempfindlichen Flächen der photovoltaischen Elemente auf den Einfall der Sonnenstrahlung aus südlicher Richtung zu einem hohen Energieertrag.

Ausgehend von dem ermittelten Stand der Technik liegt der Erfindung die Aufgabe zugrunde, eine Solarstromanlage zu schaffen, deren plattenförmige Solarstromgeneratoren im Bereich von Verkehrswegen auf eine raumsparende sowie wartungsfreundliche Weise anbringbar sind und die sich durch einen besonders hohen Energieertrag auszeichnen.

Diese Aufgabe wird erfindungsgemäß dadurch gelöst, daß der Solarstromgenerator am oberen Wandabschluß einer als Schallschutzwand ausgebildeten Einrichtung angeordnet ist, so daß er einen Teil der Schallschutzfunktion übernimmt, und in senkrechter Richtung stehend sowie sich in nord-südlicher Richtung erstreckend ausgerichtet ist, so daß die Belichtungsseiten der Solarzellenanordnung jeweils in Richtung der Morgen- und Abendsonne weisen, wobei beide Belichtungsseiten zu jeder Jahreszeit im Verlauf eines Tages dem direkten Sonnenlicht ausgesetzt sind.

Dadurch, daß der beidseitig lichtempfindliche Solarstromgenerator zusammen mit seinen Solarzellen im wesentlichen senkrecht stehend mit seiner Ebene in etwa in Nord-Süd-Richtung ausgerichtet ist, weist der Solarstromgenerator übers Jahr gemittelt einen Wirkungsgrad auf, der sogar etwas höher als der übers Jahr gemittelte Wirkungsgrad eines einseitig lichtempfindlichen optimal nach Süden auf die Mittagssonne ausgerichteten Solarstromgenerators ist. So beläuft sich der Jahresertrag eines senkrecht stehenden in Nord-Süd-Richtung ausgerichteten, beidseitig lichtempfindlichen Solarstromgenerators auf 106 Prozent, wenn der Jahresertrag eines optimal auf die Mittagssonne ausgerichteten, einseitig lichtempfindlichen Solarstromgenerators zu 100 Prozent angesetzt wird. Ferner ist der Solarstromgenerator gemäß der Erfindung auch auf Schallschutzwänden, die im wesentlichen in Nord-Süd-Richtung verlaufen, auf platzsparende Weise parallel zur Schallschutzwand ausrichtbar. Darüberhinaus bildet der erfindungsgemäße Solarstromgenerator einen Teil der Schallschutzwand und trägt dadurch zum Schallschutz bei.

Um den Ertrag der Solarstromanlage weiter zu steigern, ist bei einem bevorzugten Ausführungsbeispiel der Solarstromgenerator in einem rinnenförmigen Sammelspiegel angeordnet, durch den die in die Öffnung des Sammelspiegels einfallende Strahlung auf die Belichtungsseiten des Solarstromgenerators gelenkt wird.

Diese Anordnungen sind im allgemeinen großen Windlasten ausgesetzt und müssen diesen Windlasten standhalten. Bei Ausführungsbeispielen, die dieser Bedingung besonders angepaßt sind, ist der Solarstromgenerator um eine horizontal verlaufende Achse verschwenkbar, so daß er starken Windbelastungen ausweichen kann.

Nachfolgend werden Ausführungsbeispiele der Erfindung anhand der Zeichnung näher erläutert. Es zeigen:
- Fig. 1: eine perspektivische Teilansicht einer Schallschutzwand, die gemäß der Erfindung mit plattenförmigen Solarstromgeneratoren versehen ist,
- Fig. 2: eine Draufsicht auf einen entlang der Schnittlinie II-II in Fig. 1 geschnittenen, auf der Schallschutzwand angeordneten Solarstromgenerator,
- Fig. 3: eine Draufsicht auf einen entlang der Schnittlinie III-III in Fig. 2 geschnittenen Haltepfosten,
- Fig. 4: eine Fig. 2 entsprechende Draufsicht auf einen Querschnitt durch einen Solarstromgenerator, dem ein Sammelspiegel mit halbkreisförmigem Querschnitt zugeordnet ist,
- Fig. 5: einen Fig. 2 entsprechende Draufsicht auf einen Querschnitt durch einen Solarstromgenerator, wobei dem Solarstromgenerator auf beiden Seiten unter einem spitzen Winkel je ein ebener Sammelspiegel zugeordnet ist,
- Fig. 6: eine Draufsicht auf einen Querschnitt durch eine Anordnung wie in Fig. 5, bei der die Aufnahmeeinrichtung für den Solarstromgenerator verschwenkbar ist,
- Fig. 7: einen Querschnitt durch einen mit einem scharnierartigen Verbindungselement am oberen Wandabschluß angebrachten Haltepfosten für einen Solarstromgenerator gemäß Fig. 6,
- Fig. 8: eine perspektivische Teilansicht einer Schallschutzwand mit oberhalb ihres Schwerpunktes verschwenkbar angebrachten Solarstromgeneratoren und
- Fig. 9: eine perspektivische, vergrößerte Teilansicht des oberen Endes des Haltepfostens für Solarstromgeneratoren gemäß Fig. 8.

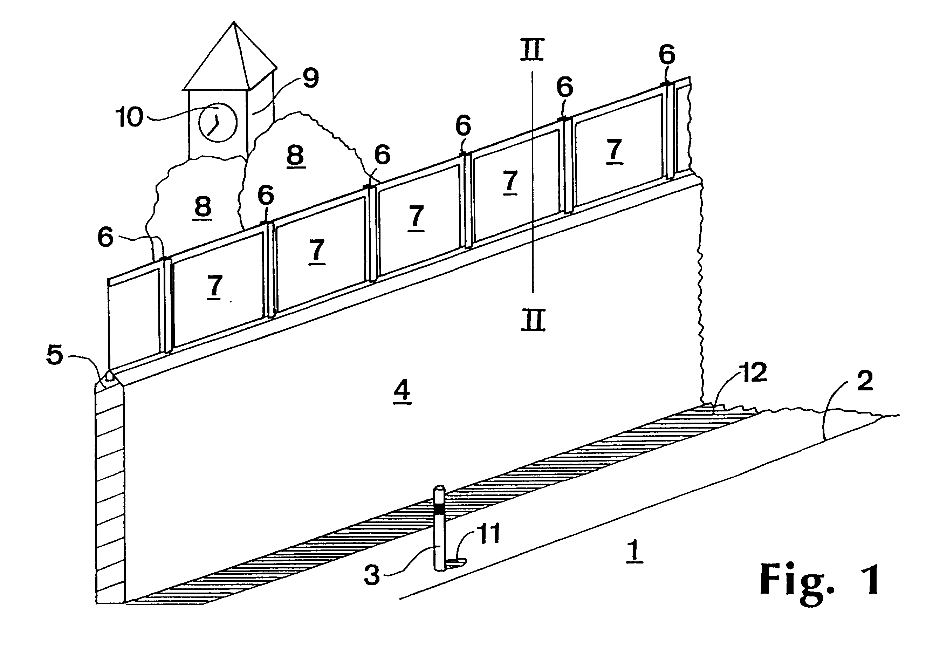

In Fig. 1 ist ein bevorzugtes Ausführungsbeispiel der vorliegenden Erfindung in einer perspektivischen Teilansicht dargestellt. Im Vordergrund erkennt man einen Verkehrsweg oder eine Fahrbahn 1, die durch einen Straßenrand 2 und einen Straßenpfosten 3 veranschaulicht ist.

Parallel zu der Fahrbahn 1 verläuft eine Schallschutzwand 4 mit einem oberen Wandabschluß 5, der satteldachförmig ausgebildet ist, um das Ablaufen von Wasser zu gestatten. Am oberen Wandabschluß 5 der Schallschutzwand 4 sind senkrecht stehend zwischen einer Vielzahl von Haltepfosten 6 plattenförmige Solarstromgeneratoren 7 einer Solarstromanlage angeordnet. Die Solarstromgeneratoren 7 sind beidseitig lichtempfindlich, um eine möglichst hohe Energieausbeute zu gestatten.

Hinter der mit den Solarstromgeneratoren 7 versehenen Schallschutzwand 4 erkennt man in Fig. 1 Bäume 8, hinter denen ein Kirchturm 9 angedeutet ist. Der Kirchturm 9 verfügt über eine Uhr 10, deren Zeiger eine Zeit kurz vor Mittag anzeigen. Da die Schallschutzwand 4 und die Fahrbahn 1 im wesentlichen in Nord-Süd-Richtung verlaufen, haben der Straßenpfosten 3 und die mit den Solarstromgeneratoren 7 versehene Schallschutzwand 4 einen kurzen Schatten 11 und 12 in nord-westlicher Richtung.

Eine derartige Solarstromanlage kann einen höheren Wirkungsgrad haben als eine herkömmliche Solarstromanlage mit einseitig lichtempfindlichen Solarstromgeneratoren. Dies zeigt die folgende Abschätzung. Zunächst sei der Jahresertrag eines mit seiner Längsachse in Ost-West-Richtung angeordneten, optimal auf die Sonne ausgerichteten, einseitig lichtempfindlichen Solarstromgenerators mit 100 Prozent angesetzt. Dann ergibt sich aus den Kurven, die für die jährlichen Bestrahlungsstärken von West- und Ostfassaden von Häusern ermittelt wurden, der Jahresertrag eines senkrecht stehenden in Nord-Süd-Richtung ausgerichteten, einseitig lichtempfindlichen Solarstromgenerators zu 53 Prozent. Für den beidseitig lichtempfindlichen Solarstromgenerator 7, bei dem beide Belichtungsseiten den gleichen Wirkungsgrad wie die Belichtungsseite eines einseitig lichtempfindlichen Solarstromgenerators haben, ergibt sich demnach der Jahresertrag als Summe der Beiträge von beiden Belichtungsseiten zu 106 Prozent. Diese Zahl ändert sich nicht sehr, wenn von der genauen Nord-Süd-Ausrichtung abgegangen wird, so daß eine derartige Anordnung auch bei anderen Himmelsrichtungen anwendbar ist.

Neben dem hohen Wirkungsgrad weist eine Anlage gemäß Fig. 1 eine Reihe von weiteren Vorteilen auf.

Infolge der Aufteilung der Solarstromgeneratoren 7 in einzelne plattenförmige Module ist die Solarstromanlage wartungsfreundlich, da die Solarstromgeneratoren 7 leicht und einfach einzeln ausgetauscht werden können.

Wegen der Ausrichtung der Solarstromgeneratoren 7 mit ihren Längsachsen parallel zur Schallschutzwand 4 lassen sich die Solarstromgeneratoren 7 bequem mit einem an der Schallschutzwand 4 entlangfahrenden Reinigungsfahrzeug reinigen.

Aufgrund der senkrechten Anordnung der Solarstromgeneratoren 7 ist die Gefahr der Strahlungskühlung mit nachfolgender Rauhreif- und Taubildung geringer, da die Belichtungsseiten der Solarstromgeneratoren 7 hauptsächlich der Wärmestrahlung von Gegenständen in ihrer Umgebung ausgesetzt sind, so daß die Strahlungskühlung durch einen gelegentlich klaren Nachthimmel geringer ausfällt.

Außerdem können Verschmutzungen, die die Belichtungsseiten der Solarstromgeneratoren 7 in einem begrenzten Gebiet abdecken, sich nur schwer auf den senkrecht stehenden Solarstromgeneratoren 7 ablagern, da diese einem fallenden Gegenstand bei senkrechter Anordnung keine Ablagerungsfläche bieten.

Ein weiterer Vorteil senkrechter Anordnung ist schließlich , daß die auf der Schallschutzwand 4 senkrecht stehenden Solarstromgeneratoren 7 mit ihrer ganzen Fläche auch einen Teil der Schallschutzfunktion übernehmen.

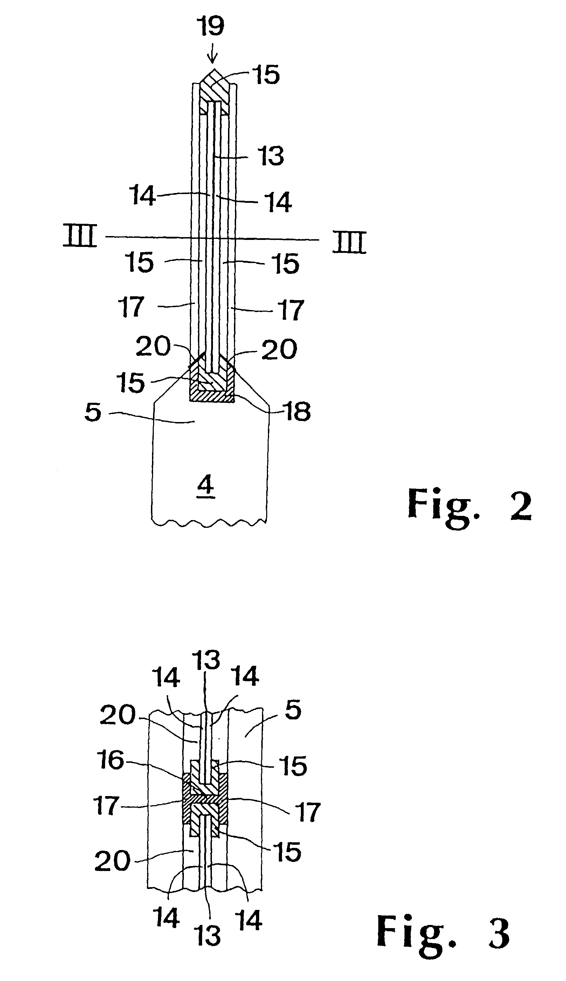

Fig. 2 zeigt eine Draufsicht auf den entlang der Schnittlinie II-II in Fig. 1 geschnitten, am oberen Wandabschluß 5 angeordneten Solarstromgenerator 7. Der Solarstromgenerator 7 verfügt über 0,1 Millimeter starke, beidseitig lichtempfindliche Solarzellen 13, wie zum Beispiel beidseitig lichtempfindliche MIS-Solarzellen. Die Solarzellen 13 sind zwischen zwei stützenden Glasplatten 14 eingebracht, die an ihren Rändern durch eine Einfassung 15 verstärkt sind. Die Einfassung 15 kann sowohl an der den Glasplatten 14 abgewandten Seite als auch an der den Glasplatten 14 zugewandten Seite abgeschrägt sein, um den Ablauf von Wasser zu ermöglichen und um die Abschattung des Sonnenlichts zu verringern.

Fig. 3 zeigt eine Draufsicht auf den entlang der Schnittlinie III-III in Fig. 2 geschnittenen Haltepfosten 6. Da die Schallschutzwand 4 für Luftströmungen ein Strömungshindernis darstellt, können im Bereich des oberen Wandabschlusses 5 hohe Windgeschwindigkeiten auftreten, die eine große Windlast erzeugen. Um den Solarstromgenerator 7 gegen Windkraft abzustützen, sind die Haltepfosten 6 mit einem Doppel-T-Profil versehen, das einen Steg 16 und Flansche 17 aufweist. Die Haltepfosten 6 sind dabei so ausgerichtet, daß die Flansche 17 parallel zur Ebene der Schallschutzwand 4 verlaufen und daß der die beiden Flansche 17 vebindende Steg 16 des Doppel-T-Profils quer zur Schallschutzwand 4 steht. Dementsprechend sind in Fig. 2 nur je eine Vorderkante der beiden Flansche 17 zu erkennen.

Zwischen den Haltepfosten 6 verläuft eine in dem oberen Wandabschluß 5 eingebrachte Haltemulde 18. Zusammen mit den beidseitig der Solarstromgeneratoren 7 angeordneten Haltepfosten 6 bildet die Haltemulde 18 eine U-rahmenförmige Aufnahmeeinrichtung 19, in die jeweils der mit der Einfassung 15 versehene Solarstromgenerator 7 nach oben verschiebbar eingebracht ist. Um die von der Haltmulde 18 gebildete Vertiefung gegen das Eindringen von Wasser zu schützen, sind elastische Abdeckleisten 20 vorgesehen, die die Fugen zwischen der Haltemulde 18 und der Einfassung 15 abdichten.

Um elektrische Leitungen verdeckt und damit vor äußeren Einwirkungen geschützt an die Solarstromgeneratoren 7 heranzuführen, können der Aufnahmevorrichtung 19 und der Einfassung 15 in der Zeichnung nicht dargestellte Kabelschächte und Stecker zugeordnet sein. Dabei kann das Eigengewicht des mit der Einfassung 15 versehenen Solarstromgenerators 7 ausgenutzt werden, um Steckerverbindungen, die sich zwischen dem Boden der Haltemulde 18 und der Einfassung 15 des Solarstromgenerators 7 befinden, abzudichten.

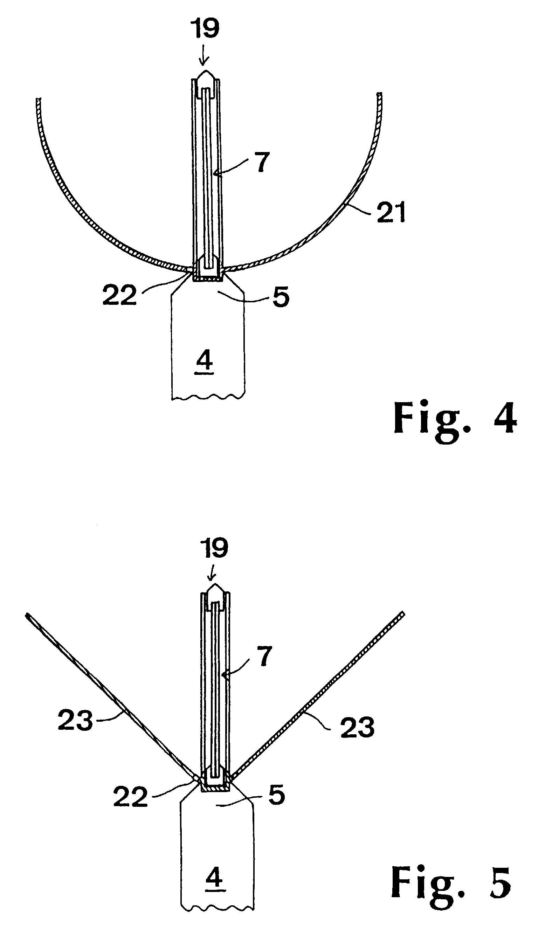

Fig. 4 zeigt ein abgewandeltes Ausführungsbeispiel, bei dem sich einzelne oder alle Solarstromgeneratoren 7 einer Solarstromanlage in einem rinnenförmigen Sammelspiegel 21 mit halbkreisförmigem Querschnitt senkrecht stehend befindet. Diese Anordnung ist zwar weniger wartungsfreundlich, ermöglicht aber dafür eine höhere Energieausbeute, da durch die verspiegelte, dem Solarstromgenerator 7 zugewandte Innenseite des Sammelspiegels 21 auch zur Mittagszeit Sonnenlicht auf den beidseitig lichtempfindlichen Solarstromgenerator 7 gelenkt wird. Außerdem vergrößert der Sammelspiegel 21 die effektive Oberfläche des Solarstromgenerators 7. Der Sammelspiegel 21 kann auf seiner dem Solarstromgenerator 7 zugewandten Seite anstatt mit metallischen Werkstoffen auch mit weißem Kunststoff beschichtet sein.

Zur Ableitung von Regenwasser und Tauwasser sowie zur Belüftung und zu Wartungszwecken weist der Sammelspiegel 21 in seinem Bodenbereich Öffnungen 22 auf. Dabei ist die Anzahl und die Gestalt der Öffnungen 22 so ausgelegt, daß das sich im Sammelspiegel 21 ansammelnde Wasser abgeführt wird, oder daß der durch die Öffnungen 22 ermöglichte Luftstrom ausreicht, um den Solarstromgenerator 7 zu kühlen. Außerdem gestatten die Öffnungen 22 das Durchführen von Wartungswerkzeugen. Auf diese Weise sind die Solarstromgeneratoren 7 beispielsweise von unten mit Reinigungswerkzeugen erreichbar. Jede dieser Aufgaben kann aber auch von Zwischenräumen übernommen werden, die sich zwischen aufeinander folgenden, entlang der Schallschutzwand 4 angeordneten Modulen der Sammelspiegel 21 befinden.

Abgesehen davon ergibt sich ein besonders wartungsfreundliches weiteres Ausführungsbeispiel, wenn die Ausdehnung des Sammelspiegels 21 eingeschränkt ist. Bei einem abgewandelten Ausführungsbeispiel folgt beispielsweise der Querschnitt des rinnenförmigen Sammelspiegels 21 nur einem Teilabschnitt eines Halbkreises. Dadurch wird zwar der Energieertrag verringert, aber dafür ist der Solarstromgenerator 7 von unten leicht mit Reinigungswerkzeugen erreichbar.

Fig. 5 zeigt ein weiteres abgewandeltes Ausführungsbeispiel der Erfindung. Dabei ist dem Solarstromgenerator 7 auf beiden Seiten unter einem spitzen Winkel ein ebener Sammelspiegel 23 zugeordnet. Diese Weiterbildung ist gegenüber der in Fig. 3 gezeigten Anordnung bezüglich der Ausbeute an reflektiertem Sonnenlicht weniger effektiv, hat aber den Vorteil, daß die Anfertigung der Sammelspiegel 23 weniger Kosten verursacht. Um einen optimalen Energieertrag zu erzielen, sind bei diesem Ausführungsbeispiel, die ebenen Sammelspiegel 23, deren Breite gleich dem Produkt der Quadratwurzel aus zwei mit der Höhe des Solarstromgenerators 7 ist, unter einem Winkel von 45 Grad dem Solarstromgenerator zugeordnet, so daß die Oberkanten der ebenen Sammelspiegel 23 und die Oberkante des Solarstromgenerators 7 in etwa auf gleicher Höhe liegen.

Bei den in den Fig. 1 bis Fig. 4 dargestellten Anordnungen ist der Solarstromgenerator 7 starr mit der Schallschutzwand 4 verbunden. Dementsprechend muß, um der Windlast standhalten zu können, die Aufnahmevorrichtung 19 ausreichend robust konstruiert sein. Eine andere Möglichkeit besteht darin, die Solarstromgeneratoren 7 verschwenkbar an der Schallschutzwand 4 anzubringen.

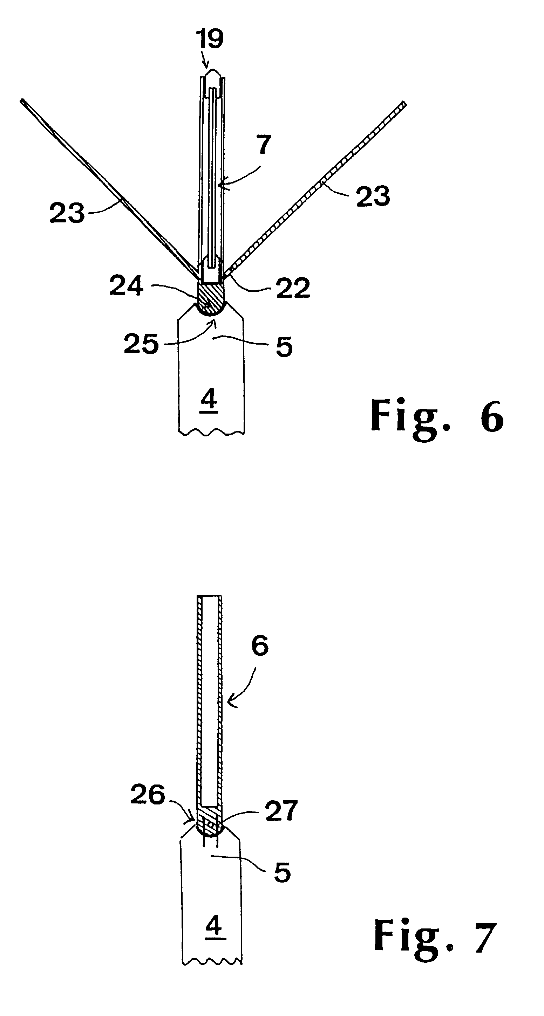

Fig. 6 zeigt ein Ausführungsbeispiel mit einer Spiegelanordnung wie in Fig. 5 mit dem Unterschied, daß die in Fig. 5 gezeigte Anordnung um eine parallel zu der Schallschutzwand 4 und horizontal verlaufende Achse verschwenkbar ist. Dementsprechend greift die U-rahmenförmige Aufnahmeeinrichtung 19 mit einer abgerundeten Ausstülpung oder Einbuchtung 24 in eine sich im oberen Wandabschluß 5 befindende, abgerundete Einbuchtung oder Ausstülpung 25 ein, so daß die Aufnahmeeinrichtung 19, die den mit der Einfassung 15 versehenen Stromgenerator 7 aufnimmt, zusammen mit den Sammelspiegeln 23 um eine horizontal und parallel zur Schallschutzwand 4 verlaufende Achse verschwenkbar ist.

Fig. 7 zeigt einen Querschnitt durch den verschwenkbaren Haltepfosten 6, wie er für die Anordnung gemäß Fig. 6 notwendig ist. Der verschwenkbare Haltepfosten 6 ist am oberen Wandabschluß 5 der Schallschutzwand 4 mittels eines scharnierartigen Verbindungselements 26 angebracht und wird durch Blattfedern 27 gestützt. Das scharnierartige Verbindungselement 26 und die Blattfedern 27 müssen nicht notwendigerweise am Haltepfosten 6 angebracht sein, sondern können auch zwischen der Aufnahmeeinrichtung 19 und dem oberen Wandabschluß 5 der Schallschutzwand 4 angeordnet sein.

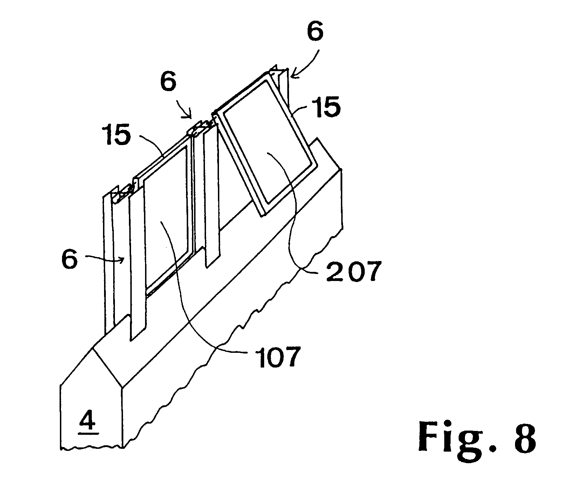

Fig. 8 veranschaulicht eine weitere Anordnung mit verschwenkbaren Solarstromgeneratoren 107 und 207, wobei der Einfachheit halber in Fig. 8 ein Ausführungsbeispiel ohne zusätzlichen feststehenden Sammelspiegel 21 dargestellt ist. In Fig. 8 erkennt man im Vordergrund den senkrecht hängenden Solarstromgenerator 107, dessen Einfassung 15 an ihrem oberen Ende verschwenkbar mit den beiden benachbarten Haltepfosten 6 verbunden ist. Seitlich zu dem senkrecht hängenden Solarstromgenerator 107 erkennt man im Hintergrund den Solarstromgenerator 207, der aus seiner senkrechten Ruhestellung ausgelenkt ist.

Bei dieser Anordnung ist die Schwenkbewegung der Solarstromgeneratoren 107 und 207 durch den Luftwiderstand gedämpft. Falls der Luftwiderstand zur Dämpfung der Schwenkbewegung nicht ausreicht, können zwischen dem oberen Wandabschluß 5 der Schallschutzwand 4 und der unteren Kante der Einfassung 15 oder seitlich zwischen den Haltepfosten 6 und der Einfassung 15 Dämpfungsvorrichtungen, wie zum Beispiel Wirbelstrombremsen, angebracht sein, um die Schwenkbewegung der Solarstromgeneratoren 107 und 207 zu dämpfen.

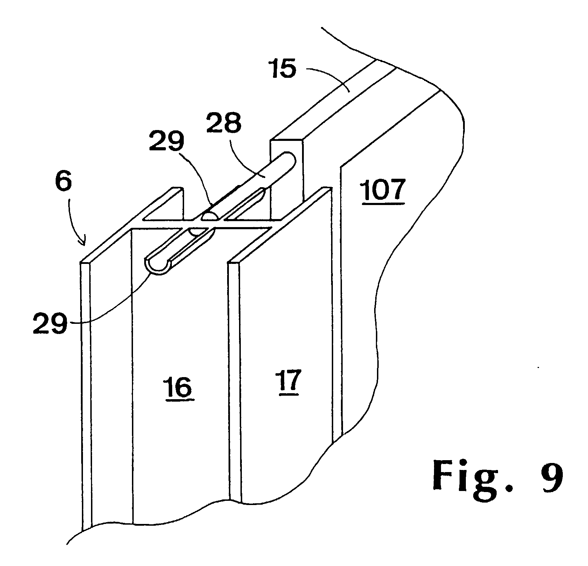

Fig. 9 zeigt in einem vergrößerten Ausschnitt die Aufhängvorrichtung gemäß Fig. 8. Um die Solarstromgeneratoren 107 und 207 über ihrem Schwerpunkt verschwenkbar zu lagern, sind an den Einfassungen 15 Zapfen 28 ausgebildet, mit denen die Solarstromgeneratoren 107 und 207 in am Haltepfosten 6 angebrachte, rinnenförmige Lager 29 eingehängt sind. Dadurch sind die Solarstromgeneratoren 107 und 207 nicht nur bei Windbelastung verschwenkbar sondern auch nach oben zu Wartungszwecken abnehmbar. Im allgemeinen ist am oberen Ende des Haltepfostens 6 eine hier nicht dargestellte Abdeckung vorhanden, die ein unbeabsichtigtes Herausspringen der Zapfen 28 verhindert.

Ferner können in den rinnenförmigen Lagern 29 und an den Zapfen 28 Schleifkontakte ausgebildet sein, um die elektrische Verbindung der Solarstromgeneratoren 107 und 207 zu gewährleisten. Solche Kontakte haben den Vorteil, daß eine nicht leitende Oxidschicht, die sich durch den Witterungseinfluß bildet, durch die bei der Bewegung der Solarstromgeneratoren 107 und 207 entstehenden Reibungskräfte ständig entfernt wird.

Eine Aufhängung oberhalb des Schwerpunktes ist nur für den mit einer Einfassung 15 versehenen Solarstromgenerator 7 selbst sinnvoll, nicht jedoch für eine Anordnung, bei der die Aufnahmevorrichtung 19 einschließlich des Solarstromgenerators 7 und des Sammelspiegels 21 oberhalb des gemeinsamen Schwerpunktes verschwenkbar aufgehängt ist. Bei einer solchen Anordnung erhöht sich der Luftwiderstand, falls der Wind die aufgehängte Aufnahmevorrichtung 19 einschließlich des Solarstromgenerators 7 und des Sammelspiegels 21 auslenkt, da dann die Öffnung des Sammelspiegels 21 dem Wind zugewandt ist.

Schließlich sei noch erwähnt, daß die in den Fig. 5 bis 9 dargestellten, verschwenkbaren Anordnungen auch dazu verwendet werden können, um den Solarstromgenerator 7, 107, 207 mittels einer motorgetriebene Stellvorrichtung der Sonne nachzuführen.

## Patentansprüche

1. Solarstromanlage mit wenigstens einem modularen, plattenförmigen Solarstromgenerator (7, 107, 207), der über eine sich entlang der Plattenebene erstreckende Solarzellenanordnung (13) verfügt, deren Solarzellen beidseitig lichtempfindlich sind, **dadurch gekennzeichnet**, daß der Solarstromgenerator (7, 107, 207) am oberen Wandabschluß (5) einer als Schallschutzwand (4) ausgebildeten Einrichtung angeordnet ist, so daß er einen Teil der Schallschutzfunktion übernimmt, und in senkrechter Richtung stehend sowie sich in nord-südlicher Richtung erstreckend ausgerichtet ist, so daß die Belichtungsseiten der Solarzellenanordnung (13) jeweils in Richtung der Morgen- und Abendsonne weisen, wobei beide Belichtungsseiten zu jeder Jahreszeit im Verlauf eines Tages dem direkten Sonnenlicht ausgesetzt sind.

2. Solarstromanlage nach Anspruch 1, dadurch gekennzeichnet, daß sich der Solarstromgenerator (7, 107, 207) in einem rinnenförmig ausgestalteten und sich parallel zum Solarstromgenerator (7, 107, 207) erstreckenden Sammelspiegel (21) befindet.

3. Solarstromanlage nach Anspruch 1, dadurch gekennzeichnet, daß der Solarstromgenerator (7, 107, 207) um eine horizontal verlaufende Achse verschwenkbar ist.

4. Solarstromanlage nach Anspruch 1, dadurch gekennzeichnet, daß der Solarstromgenerator (7) mit einer Einfassung (15) versehen und in eine U-rahmenförmige Aufnahmevorrichtung (19) nach oben verschiebbar eingebracht ist, wobei die Aufnahmevorrichtung (19) beidseitig des Solarstromgenerators angeordnete Haltepfosten (6) und eine zwischen den Haltepfosten (6) unterhalb des Solarstromgenerators (7) horizontal verlaufende Haltemulde (18) aufweist.

5. Solarstromanlage nach Anspruch 2, dadurch gekennzeichnet, daß der Querschnitt des rinnenförmig ausgestalteten Sammelspiegels (21) einen Teilkreis beschreibt, dessen Mittelpunkt in der Oberkante des Solarstromgenerators (7) liegt.

6. Solarstromanlage nach Anspruch 5, dadurch gekennzeichnet, daß der Teilkreis ein Halbkreis ist.

7. Solarstromanlage nach Anspruch 2, dadurch gekennzeichnet, daß der rinnenförmig ausgestaltete Sammelspiegel (21) zwei unter einem spitzen Winkel zum Solarstromgenerator (7) angeordnete, ebene Sammelspiegel (23) aufweist.

8. Solarstromanlage nach Anspruch 7, dadurch gekennzeichnet, daß der spitze Winkel 45 Grad beträgt und daß die Oberkanten der Sammelspiegel (23) mit der Oberkante des Solarstromgenerators (7) in etwa auf gleicher Höhe liegen.

9. Solarstromanlage nach Anspruch 1 und 3 oder den Ansprüchen 1 bis 3, dadurch gekennzeichnet, daß der Solarstromgenerator (7, 107, 207) mit einer Einfassung (15) versehen ist, an der oberhalb des Schwerpunktes des Solarstromgenerators (7, 107, 207) Zapfen (28) ausgebildet sind, die mit an Haltepfosten (6) angeordneten Lagern (29) so zusammenwirken, daß der Solarstromgenerator (7, 107, 207) quer zur Schallschutzwand (4) verschwenkbar und nach oben abnehmbar mit den am oberen Wandabschluß (5) angeordneten Haltepfosten (6) verbunden ist.

10. Solarstromanlage nach Anspruch 1, 3 und 4 oder den Ansprüchen 1 bis 4, dadurch gekennzeichnet, daß die U-rahmenförmige Aufnahmevorrichtung (19) durch mit Blattfedern (27) gestützte Verbindungselemente (26), quer zu der Schallschutzwand (4) verschwenkbar an dem oberen Wandabschluß (5) angebracht ist.

11. Solarstromanlage nach Anspruch 9 oder 10, dadurch gekennzeichnet, daß die U-rahmenförmige Aufnahmevorrichtung (19) mit einer motorgetriebenen Stellvorrichtung der Sonne nachführbar ist.

12. Solarstromanlage nach einem der Ansprüche 2 oder 5 bis 8, dadurch gekennzeichnet, daß der rinnenförmig ausgestaltete Sammelspiegel (21) öffnungen (22) in seinem Bodenbereich aufweist.

13. Solarstromanlage nach einem der Ansprüche 2 oder 5 bis 8, dadurch gekennzeichnet, daß der Sammelspiegel (21, 23) auf seiner dem Solarstromgenerator (7) zugewandten Seite mit weißem Kunststoff beschichtet ist.

## Claims

1. A solar power installation comprising at least one modular, panel-shaped solar power generator (7, 107, 207) having a solar cell arrangement (13) which extends along the plane of the panel and whose solar cells are light-sensitive on both sides, characterised in that the solar power generator (7, 107, 207) is arranged at the upper wall edge (5) of an apparatus in the form of a sound-protection wall (4) so that it takes over a part of the sound-protection function, and is arranged to stand in a perpendicular direction and extend in a North-South direction so that the illumination sides of the solar cell arrangement (13) respectively face in the direction of the morning sun and the evening sun, wherein both illuminations sides are exposed to the direct sunlight in the course of a day at any time of the year.

2. A solar power installation according to claim 1 characterised in that the solar power generator (7, 107, 207) is disposed in a converging mirror (21) which is of a channel-shaped configuration and which extends parallel to the solar power generator (7, 107, 207).

3. A solar power installation according to claim 1 characterised in that the solar power generator (7, 107, 207) is pivotable about a horizontally extending axis.

4. A solar power installation according to claim 1 characterised in that the solar power generator (7) is provided with an edge assembly (15) and is fitted displaceably upwardly into a receiving arrangement (19) in the form of a U-shaped frame, wherein the receiving arrangement (19) has holding posts (6) arranged on both sides of the solar power generator and a holding cradle (18) extending horizontally between the holding posts (6) beneath the solar power generator (7).

5. A solar power installation according to claim 2 characterised in that the cross-section of the converging mirror (21) of a channel-like configuration describes part of a circle, the centre point of which is at the top edge of the solar power generator (7).

6. A solar power installation according to claim 5 characterised in that the part of a circle is a semicircle.

7. A solar power installation according to claim 2 characterised in that the converging mirror (21) of a channel-like configuration has two flat converging mirrors (23) which are arranged at an acute angle relative to the solar power generator (7).

8. A solar power installation according to claim 7 characterised in that the acute angle is 45 degrees and that the top edges of the converging mirrors (23) are at approximately the same height as the top edge of the solar power generator (7).

9. A solar power installation according to claim 1 and claim 3 or claims 1 to 3 characterised in that the solar power generator (7, 107, 207) is provided with an edge assembly (15) on which above the centre of gravity of the solar power generator (7, 107, 207) are provided pins (28) cooperating with mountings (29) arranged on holding posts (6), in such a way that the solar power generator (7, 107, 207) is connected pivotably transversely with respect to the sound-protection wall (4) and removably upwardly to the holding posts (6) arranged at the upper wall edge (5).

10. A solar power installation according to claim 1, claim 3 and claim 4 or claims 1 to 4 characterised in that the receiving arrangement (19) in the form of a U-shaped frame is mounted to the upper wall edge (5) pivotably transversely with respect to the sound-protection wall (4) by connecting elements (26) which are supported with leaf springs (27).

11. A solar power installation according to claim 9 or claim 10 characterised in that the receiving arrangement (19) in the form of a U-shaped frame is capable of tracking the sun with a motor-driven control device.

12. A solar power installation according to one of claims 2 or 5 to 8 characterised in that the converging mirror (21) which is of a channel-like configuration has openings (22) in its bottom region.

13. A solar power installation according to one of claims 2 or 5 to 8 characterised in that the converging mirror (21. 23) is coated with white plastics material on its side that faces towards the solar power generator (7).

## Revendications

1. Installation d'énergie solaire comportant au moins un générateur d'énergie solaire (7, 107, 207), modulaire, en forme de panneau, lequel dispose d'un agencement (13) de cellules solaires s'étendant le long du plan dudit panneau, et dont les cellules solaires sont photosensibles sur leurs deux faces, caractérisée en ce que le générateur d'énergie solaire (7, 107, 207) est disposé à 'extrémité supérieure (5) d'un dispositif réalisé sous la forme d'un mur insonorisant (4), de telle sorte que ledit générateur assume une partie de la fonction d'insonorisation, et s'étend en direction verticale ainsi qu'en direction nord-sud, ce qui a pour effet que les faces éclairées de l'agencement (13) de cellules solaires sont orientées respectivement vers le soleil levant et le soleil couchant, les deux faces éclairées étant donc exposées en toute saison à la lumière solaire directe pendant la durée du jour.

2. Installation d'énergie solaire selon la revendication 1, caractérisée en ce que le générateur d'énergie solaire (7, 107, 207) se trouve à l'intérieur d'un miroir concave (21) réalisé en forme de goulotte, qui s'étend parallèlement au générateur d'énergie solaire (7, 107, 207).

3. Installation d'énergie solaire selon la revendication 1, caractérisée en ce que le générateur d'énergie solaire (7, 107, 207) est pivotable autour d'un axe s'étendant horizontalement.

4. Installation d'énergie solaire selon la revendication 1, caractérisée en ce que le générateur d'énergie solaire (7) est muni d'une monture (15) et incorporé dans un dispositif de positionnement (19) en forme de cadre en U pouvant coulisser vers le haut, ledit dispositif (19) présentant des montants de retenue (6) disposés des deux cotés du générateur d'énergie solaire, et une moulure de retenue (18) s'étendant horizontalement entre les montants (6) sous le générateur solaire (7).

5. Installation d'énergie solaire selon la revendication 2, caractérisée en ce que la section transversale du miroir (21) réalisée en forme de goulotte décrit un arc de cercle dont le centre se situe dans l'arête supérieure du générateur d'énergie solaire (7).

6. Installation d'énergie solaire selon la revendication 5, caractérisée en ce que l'arc de cercle est un demi-cercle.

7. Installation d'énergie solaire selon la revendication 2, caractérisée en ce que le miroir (21) réalisé en forme de goulotte présente deux miroirs plans (23) disposés de manière à former un angle aigu par rapport au générateur d'énergie solaire (7).

8. Installation d'énergie solaire selon la revendication 7, caractérisée en ce que l'angle aigu est de 45 degrés, et que les arêtes supérieures des miroirs (23) se situent sensiblement à la même hauteur que l'arête supérieure du générateur d'énergie solaire (7).

9. Installation d'énergie solaire selon les revendications 1 et 3 ou les revendications 1 à 3, caractérisée en ce que le générateur d'énergie solaire (7, 107, 207) est muni d'une monture (15) sur laquelle sont conformés, au-dessus du centre de gravité du générateur d'énergie solaire (7, 107, 207), des pivots (28) qui coopèrent avec des paliers (29) disposés sur les montants de retenue (6), de telle sorte que le générateur d'énergie solaire (7, 107, 207) est pivotable transversalement par rapport au mur insonorisant (4), et relié, de manière amovible vers le haut, avec les montants de retenue (6) disposés sur l'extrémité supérieure (5) du mur.

10. Installation d'énergie solaire selon les revendications 1, 3 et 4, ou les revendications 1 à 4, caractérisée en ce que le dispositif de positionnement (19) en forme de cadre en U est fixé par des éléments d'assemblage (26) renforcés par des ressorts à lames (27), sur l'extrémité murale supérieure (5), de manière à pouvoir basculer transversalement par rapport au mur insonorisant (4).

11. Installation d'énergie solaire selon la revendication 9 ou 10, caractérisée en ce que le dispositif de positionnement (19) en forme de cadre en U peut suivre le trajet du soleil au moyen d'un dispositif de réglage entraîné par un moteur.

12. Installation d'énergie solaire selon l'une des revendications 2 ou 5 à 8, caractérisée en ce que le miroir (21) conformé en forme de goulotte présente des orifices (22) dans la région du fond.

13. Installation d'énergie solaire selon l'une des revendications 2 ou 5 à 8, caractérisée en ce que le miroir (21,23) est revêtu d'une couche en matière synthétique blanche sur sa face orientée vers le générateur d'énergie solaire (7).
